# EUROPEAN PATENT SPECIFICATION

(11) **EP 4 510 137 B1**
(45) Date of publication and mention of the grant of the patent: **21.10.2026**
(21) Application number: 23841922.0
(22) Date of filing: 01.06.2023
(51) Int. Cl.: G11C 29/44, G11C 29/00, G06F 11/07

(54) **METHOD AND APPARATUS FOR DETERMINING MEMORY FAULT REPAIR MODE, AND STORAGE MEDIUM**
VERFAHREN UND VORRICHTUNG ZUR BESTIMMUNG EINES SPEICHERFEHLERREPARATURMODUS UND SPEICHERMEDIUM
PROCÉDÉ ET APPAREIL DE DÉTERMINATION DE MODE DE RÉPARATION DE DÉFAILLANCE DE MÉMOIRE, ET SUPPORT DE STOCKAGE

(30) Priority: 22.07.2022 CN 202210873547
(43) Date of publication of application: 19.02.2025
(73) Proprietor: xFusion Digital Technologies Co., Ltd., Zhengzhou, Henan 450046 (CN)
(72) Inventor: ZHANG, Guangbiao, Zhengzhou, Henan 450046 (CN); BAO, Quanyang, Zhengzhou, Henan 450046 (CN); WEI, Weiwei, Zhengzhou, Henan 450046 (CN); LI, Sheng, Zhengzhou, Henan 450046 (CN); GAN, Yan, Zhengzhou, Henan 450046 (CN); CAO, Rui, Zhengzhou, Henan 450046 (CN)
(74) Representative: MERH-IP Matias Erny Reichl Hoffmann Patentanwälte PartG mbB
(86) International application number: PCT/CN2023/097852
(87) International publication number: WO 2024/016855

(56) References cited:
- WO-A1-2022/028209
- CN-A- 110 618 890
- CN-A- 113 821 364
- CN-A- 114 064 333
- CN-A- 114 691 409
- CN-A- 115 394 344
- KR-A- 20220 094 489
- US-A1- 2012 069 689
- US-A1- 2018 210 782
- US-A1- 2020 111 539
- US-B1- 10 871 910

## Description

### TECHNICAL FIELD

Embodiments of this application relate to the field of computer technologies, and in particular, to a method for determining a memory fault repair manner, an apparatus, and a storage medium.

### BACKGROUND

With widespread application of Internet technologies, memory reliability has become a focus of attention of major enterprises. Through data statistics, it is found that a row (Row) fault in a memory is one of factors that reduce memory reliability and cause server breakdown. A conventional manner of handling a row fault is a post-package repair (post-package repair, PPR) manner.

As is known to all, in the foregoing PPR manner, a memory is divided into a redundant storage area and a storage area. The storage area is configured to store data, and the redundant storage area is configured to replace a faulty area in the storage area. The PPR manner includes a soft post-package repair (soft post-package repair, sPPR) manner and a hardware post-package repair (hardware post-package repair, hPPR) manner. In the sPPR manner, an idle storage area in the redundant storage area is used to replace the faulty area within a predetermined time. The predetermined time starts from a moment at which the sPPR manner is triggered when a restart occurs on a server in which the memory is located and lasts until a next restart occurs on the server. The hPPR manner is to permanently replace the faulty area by using an idle storage area in the redundant storage area. Trigger occasions of the hPPR and sPPR manners are both a time of the first restart performed by the server in which the memory is located after the fault occurs.

A conventional specific process of handling a row fault based on PPR includes: a baseboard management controller (baseboard management controller, BMC) records an address of a first row fault when receiving first row fault information; and when receiving second row fault information, records an address of a second row fault, and deletes the previously recorded address of the first row fault. By analogy, when a server on which the BMC is located restarts, the BMC repairs, according to preset sPPR or hPPR, a row fault recorded by the BMC last time before the server restarts.

The foregoing BMC handles a target row fault according to the preset sPPR or hPPR, which causes waste of storage resources in the redundant storage area and reduced memory reliability.

US2020/111539A1 discloses first performing a software repair of a region when the number of correctable error and the frequency of position information satisfy certain conditions, and then performing hardware repair of the region when the software repair of the region already present.
US2018/210782A1 discloses a logic unit, LU, 230 included in a mapped redundant array of independent disks, RAID, architecture 200 defining the type of errors and recording an error tag for each type of errors to facilitate counting the errors.
US10871910B1 discloses a controller determining a data type by applying machine learning models or algorithms.
WO2022/028209A1 discloses a management module utilizing machine learning algorithms to identify failure patterns in memory based on error information, or employing isolation repair techniques to fix memory issues.

### SUMMARY

Embodiments of this application provide a method for determining a memory fault repair manner, an apparatus, and a storage medium, to improve memory reliability.

To achieve the foregoing objective, the following technical solutions are used in embodiments of this application.

According to a first aspect, an embodiment of this application provides a method for determining a memory fault repair manner. The method includes: obtaining information about a plurality of row faults, where information about a row fault includes an occurrence ranking of the row fault and a severity of the row fault, the occurrence ranking of the row fault is a quantity of row faults occurring on the memory within a target time period, and the target time period is a time period from a last restart time of a server in which the memory is located to an occurrence time of the row fault; determining a first target row fault from the plurality of row faults based on a severity of each of the plurality of row faults; and determining a repair manner of the first target row fault based on an occurrence ranking of the first target row fault and a severity of the first target row fault.

In the method for determining a memory fault repair manner provided in this embodiment of this application, the repair manner of the first target row fault is determined based on the occurrence ranking of the first target row fault and the severity of the first target row fault. Compared with a conventional manner of repairing the first target row fault according to preset sPPR or hPPR (preset manner for short), the solution in this embodiment of this application can adaptively select a PPR repair manner based on the occurrence ranking of the first target row fault and the severity of the first target row fault. Therefore, a problem of resource waste in a redundant storage area of the memory and a problem of reduced memory reliability caused by an inconsistency between a repair manner actually required for a row fault and a preset repair manner in the conventional preset manner are resolved.

The determining a repair manner of the first target row fault based on an occurrence ranking of the first target row fault and a severity of the first target row fault includes: when the occurrence ranking of the first target row fault is greater than a quantity threshold and the severity of the first target row fault is greater than a second severity, or when the occurrence ranking of the first target row fault is equal to a quantity threshold and the severity of the first target row fault is greater than a second severity, when the occurrence ranking of the first target row fault is greater than a quantity threshold and the severity of the first target row fault is greater than or equal to a second severity, the repair manner of the first target row fault is a hardware post-package repair method; or when the occurrence ranking of the first target row fault is equal to a quantity threshold and the severity of the first target row fault is equal to a second severity, the repair manner of the first target row fault is one of a hardware post-package repair method or a soft post-package repair method; otherwise, the repair manner of the first target row fault is a soft post-package repair method.

In a possible implementation, information about a row fault specifically includes an occurrence ranking of the row fault and a health score of the row fault, and the health score is configured to identify a severity of the row fault.

The information about the plurality of row faults further includes address information and quantities of Bit faults and/or Cell faults in the row faults. The method further includes: inputting the address information and the quantities of Bit faults and/or Cell faults in the row faults into a scoring model to obtain the severities of the plurality of row faults, where the scoring model is configured to assess a severity of a row fault.

In a possible implementation, the determining a first target row fault from the plurality of row faults includes: determining the first target row fault from the plurality of row faults based on the severity of each of the plurality of row faults, where the plurality of row faults are row faults that occur on the memory in a same restart time interval, the restart time interval is configured to indicate a time period from the last restart time of the server to a current restart time of the server, and the severity of the first target row fault is greater than or equal to a first severity.

Compared with a conventional manner that the last row fault in a restart time interval is repaired, in this embodiment of this application, a row fault with a higher severity in at least two row faults is determined as a first target row fault based on health scores of the at least two row faults, and then, the first target row fault with the higher severity is repaired. In this way, a case in which a row fault with a lower severity is repaired but a row fault with a higher severity is ignored is avoided. Therefore, memory stability is improved, and a probability of service interruption is reduced.

In a possible implementation, when there is an idle row in a redundant storage area in the memory, a second target row fault is determined from at least one non-target row fault based on a severity of each of the at least one non-target row fault, where the at least one non-target row fault is a non-target row fault that occurs on the memory in a same restart time interval, a severity of the second target row fault is greater than or equal to a third severity, and a repair manner of the second target row fault is a soft post-package repair manner. The second target row fault is repaired according to the repair manner of the second target row fault.

Compared with a conventional manner that only the first target row fault is repaired, in the method for determining a memory fault repair manner provided in this embodiment of this application, after the first target row fault is repaired, if there is an idle row in the redundant storage area of the memory, a determining apparatus determines, from at least one non-target row fault, a second target row fault whose severity is relatively high and whose repair manner is sPPR, and repairs the second target row fault, so that utilization of the redundant storage area is improved, and memory reliability is improved.

According to a second aspect, an embodiment of this application provides a determining apparatus. The determining apparatus includes an obtaining module and a determining module. The obtaining module is configured to obtain information about a plurality of row faults, where information about a row fault includes an occurrence ranking of the row fault and a severity of the row fault, the occurrence ranking of the row fault is a quantity of row faults occurring on a memory within a target time period, and the target time period is a time period from a last restart time of a server in which the memory is located to an occurrence time of the row fault. The determining module is configured to determine a first target row fault from the plurality of row faults based on a severity of each of the plurality of row faults. The determining module is further configured to determine a repair manner of the first target row fault based on an occurrence ranking of the first target row fault and a severity of the first target row fault.

The determining a repair manner of the first target row fault based on an occurrence ranking of the first target row fault and a severity of the first target row fault includes: when the occurrence ranking of the first target row fault is greater than a quantity threshold and the severity of the first target row fault is greater than a second severity, or when the occurrence ranking of the first target row fault is equal to a quantity threshold and the severity of the first target row fault is greater than a second severity, or when the occurrence ranking of the first target row fault is greater than a quantity threshold and the severity of the first target row fault is greater than or equal to a second severity, the repair manner of the first target row fault is a hardware post-package repair method; when the occurrence ranking of the first target row fault is equal to a quantity threshold and the severity of the first target row fault is equal to a second severity, the repair manner of the first target row fault is one of a hardware post-package repair method or a soft post-package repair method; otherwise, the repair manner of the first target row fault is a soft post-package repair method.

In a possible implementation, information about a row fault specifically includes an occurrence ranking of the row fault and a health score of the row fault, and the health score is configured to identify a severity of the row fault.

The determining apparatus further includes a processing module. The processing module is configured to input address information and quantities of Bit faults and/or Cell faults in the row faults that are included in the information about the plurality of row faults into a scoring model, to obtain the severities of the plurality of row faults. The scoring model is configured to assess a severity of a row fault.

In a possible implementation, the determining module is configured to determine the first target row fault from the plurality of row faults based on the severity of each of the plurality of row faults. The plurality of row faults are row faults that occur on the memory in a same restart time interval, the restart time interval indicates a time period from the last restart time of the server to a current restart time of the server, and the severity of the first target row fault is greater than or equal to a first severity.

In a possible implementation, the determining apparatus further includes a repair module. The determining module is configured to: when there is an idle row in a redundant storage area in the memory, determine a second target row fault from at least one non-target row fault based on a severity of each of the at least one non-target row fault, where the at least one non-target row fault is a non-target row fault that occurs on the memory in a same restart time interval, a severity of the second target row fault is greater than or equal to a third severity, and a repair manner of the second target row fault is a soft post-package repair manner. The repair module is configured to repair the second target row fault according to the repair manner of the second target row fault.

According to a first example that is not encompassed by the claims but useful for understanding the invention, an embodiment of this application provides a determining apparatus, including a storage and a processor. The storage is coupled to the processor. The storage is configured to store computer program code, where the computer program code includes computer instructions. When the computer instructions are executed by the processor, the determining apparatus is enabled to perform the method according to any one of the first aspect and the possible implementations of the first aspect.

According to a second example that is not encompassed by the claims but useful for understanding the invention, an embodiment of this application provides a computer-readable storage medium, where the computer-readable storage medium stores computer instructions. When the computer instructions are run on a computing device, the computing device is enabled to perform the method according to any one of the first aspect and the possible implementations of the first aspect.

According to a third example that is not encompassed by the claims but useful for understanding the invention, an embodiment of this application provides a computer program product, and when the computer program product runs on a computer, the computer is enabled to perform the method according to any one of the first aspect and the possible implementations of the first aspect.

According to a third aspect, an embodiment of this application provides a computing device comprising a storage and a processor. The storage is coupled to the processor, the storage is configured to store computer program code, the computer program code comprises computer instructions, and when the computer instructions are executed by the processor, the processor is enabled to perform the method according to any one of the first aspect.

It should be understood that for beneficial effects obtained from the technical solutions of the second aspect to the third aspect and the first example to the third example of the embodiments of this application and the corresponding possible implementations, refer to the foregoing technical effects of the first aspect and the corresponding possible implementations. Details are not described herein again.

### BRIEF DESCRIPTION OF DRAWINGS

FIG. 1 is a schematic diagram of a hardware structure of a server according to an embodiment of this application;
FIG. 2 is a schematic diagram of a hierarchical structure of a server according to an embodiment of this application;
FIG. 3 is a schematic flowchart 1 of a method for determining a memory fault repair manner according to an embodiment of this application;
FIG. 4 is a schematic diagram of a relationship between a row fault and a restart time according to an embodiment of this application;
FIG. 5 is a schematic flowchart 2 of a method for determining a memory fault repair manner according to an embodiment of this application;
FIG. 6 is a schematic flowchart 3 of a method for determining a memory fault repair manner according to an embodiment of this application; and
FIG. 7 is a schematic diagram of a structure of a determining apparatus according to an embodiment of this application.

### DESCRIPTION OF EMBODIMENTS

In this specification, the term "and/or" merely describes an association relationship between associated objects, and indicates that there may be three relationships, for example, A and/or B may indicate three cases: A exists alone, both A and B exist, and B exists alone.

The terms "first", "second", and the like in the specification and claims of the embodiments of this application are used to distinguish between different objects, and are not used to describe a specific sequence of objects. For example, a first preset severity and a second preset severity are used to distinguish between different preset severities, and are not used to describe a specific sequence of preset severities.

In embodiments of this application, words such as "exemplarily" or "for example" are used to represent examples, illustrations, or descriptions. Any embodiment or design solution described as "exemplarily" or "for example" in embodiments of this application should not be construed as being more preferred or advantageous than other embodiments or design solutions. Exactly, use of the words such as "exemplarily" or "for example" is intended to present relevant concepts in a specific manner.

The architecture scenario described in embodiments of this application is to describe the technical solutions in the embodiments of this application more clearly, and does not constitute a limitation on the technical solutions provided in the embodiments of this application. A person of ordinary skill in the art may learn that, with evolution of a computer system, the technical solutions provided in the embodiments of this application are also applicable to a similar technical problem.

First, some concepts involved in a method for determining a memory fault repair manner, an apparatus, and a storage medium that are provided in embodiments of this application are described.

A row fault is a fault of a corrected error (corrected error, CE) or an uncorrected error (uncorrected error, UCE) that occurs in a row (Row) in a memory. Physical granularities of the memory in descending order are successively Dimm, Rank, Device, Bank, Row/Column, Cell, and Bit. That is, a memory fault includes at least one of a Dimm fault, a Rank fault, a Device fault, a Bank fault, a Row fault/Column fault, a Cell fault, and a Bit fault.

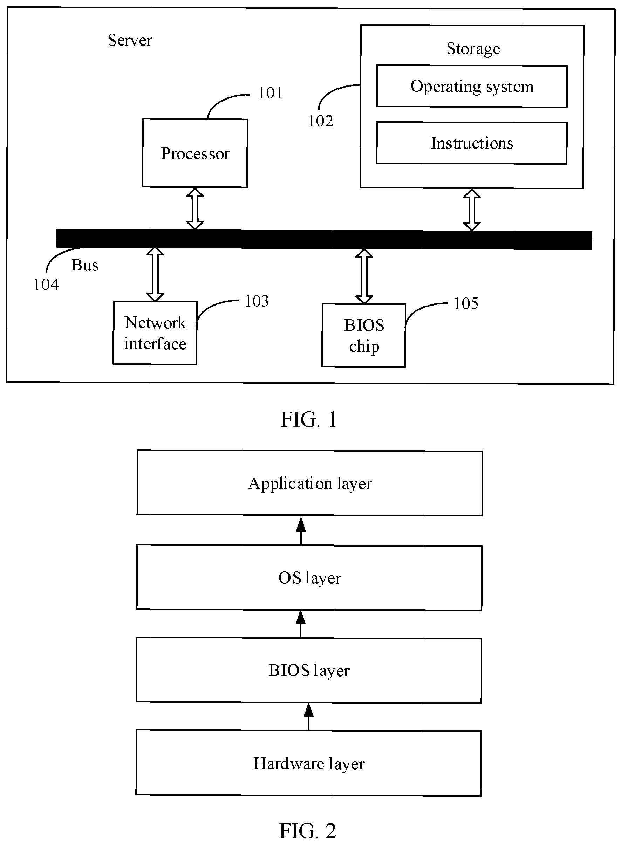

FIG. 1 is a schematic diagram of a server according to an embodiment of this application. The server includes a processor 101, a storage 102, a network interface 103, a bus 104, and a basic input output system (basic input output system, BIOS) chip 105.

The processor 101 is a control center of the server, and the processor 101 includes one or more CPUs. The CPU may be a single-core CPU (single-CPU) or a multi-core CPU (multi-CPU). The processor 101 is configured to read an operating system (operating system, OS) in the storage 102, to generate a virtual OS unit.

The storage 102 is a cache space, and may cache an operating system program, a software application program, and the like. The storage 102 is configured to interact with the processor 101, and send fault information generated in the interaction process to the BIOS chip 105.

The network interface 103 is a wired interface (port), for example, an FDDI or a GE interface. Alternatively, the network interface 103 is a wireless interface. It should be understood that the network interface 103 includes a plurality of physical ports, and the network interface 103 is configured to obtain a feature set and the like.

The bus 104 is configured to connect the processor 101, the storage 102, the network interface 103, and the BIOS chip 105 to each other.

The BIOS chip 105 is configured to run a BIOS system (BIOS for short). The BIOS is an unalterable startup program that is burned on a read-only memory (Read-Only Memory, ROM) of a mainboard, and is the most fundamental software code loaded on a hardware system of a computer device. The BIOS is responsible for a computing system self-test program and a system self-start program, and is the first program after the computer system starts. A main function of the BIOS is to control a basic program after the computer device starts, for example, repair a row fault sent by the storage 102 when the server starts. Each row fault in the memory is caused by a plurality of Bit faults and/or Cell faults. That is, when a quantity of Bit faults and/or Cell faults in the memory reaches a threshold, the memory reports a row fault. It should be noted that, that the BIOS chip 105 performs a step (for example, a step of repairing a fault of a memory) described below may mean that the processor invokes the BIOS chip 105 to perform the step.

Optionally, the server may further include a baseboard management controller (Baseboard Management Controller, BMC) chip. The BMC chip may be integrated onto the mainboard, or may be plugged into the mainboard. The BMC system is a small operating system independent of the system of the computer device. The external manifestation of the BMC system is a standard network interface with an independent IP firmware system. In addition, the BMC system does not depend on other hardware (such as a CPU or a memory) of the computer device. However, the BMC chip may interact with the BIOS chip 105 to obtain row fault information in the BIOS chip 105 that is sent by the storage 102. The BMC chip determines a repair manner of the row fault based on the row fault information. After the BMC chip determines the repair manner of the row fault, the BMC chip sends an address of the to-be-repaired row fault and the repair manner of the row fault (repair information for short) to the BIOS chip 105, so that the BIOS chip 105 repairs the row fault based on the repair information.

FIG. 1 is merely a schematic diagram of a structure of a server applicable to embodiments of this application, and does not constitute a limitation to a server applicable to embodiments of this application. For example, the server may further include a persistent storage medium, a communication interface, a communication line, and the like, which are not shown in FIG. 1.

The server includes a hardware layer and a software layer. The software layer is program code that runs at the hardware layer. The software layer can be further divided into several layers. The layers communicate with each other through a software interface. The software layer includes an application layer, an OS layer, and a BIOS layer from top to bottom, as shown in FIG. 2.

The application layer includes a series of program code for running an application program.

The OS layer includes operating system program code. The operating system may be Linux, Windows, vxWorks, or the like. A basic processing unit of the OS layer is a memory page. It should be noted that, that the OS layer performs a step described below may mean that the processor 101 invokes the OS to perform the step.

The BIOS layer is the most fundamental software code loaded on a computer hardware system. The BIOS layer is a lower layer running program under the OS layer, is an abstraction layer between the computer hardware and the OS layer, and is used to perform setting for the hardware and prepare for running of the OS layer. Main functions of the BIOS layer are power-on, self-test, CPU initialization, memory initialization, detection of input/output devices and bootable devices, and finally booting up the operating system. It should be noted that, that the BIOS layer performs a step described below may mean that the processor 101 invokes the BIOS to perform the step.

The hardware layer includes computer hardware such as a processor (for example, a CPU), a memory, and a memory controller, as shown in FIG. 1.

It should be noted that an apparatus for performing the method for determining a memory fault repair manner (a determining apparatus for short) provided in embodiments of this application may be the BMC or the processor in the server shown in FIG. 1.

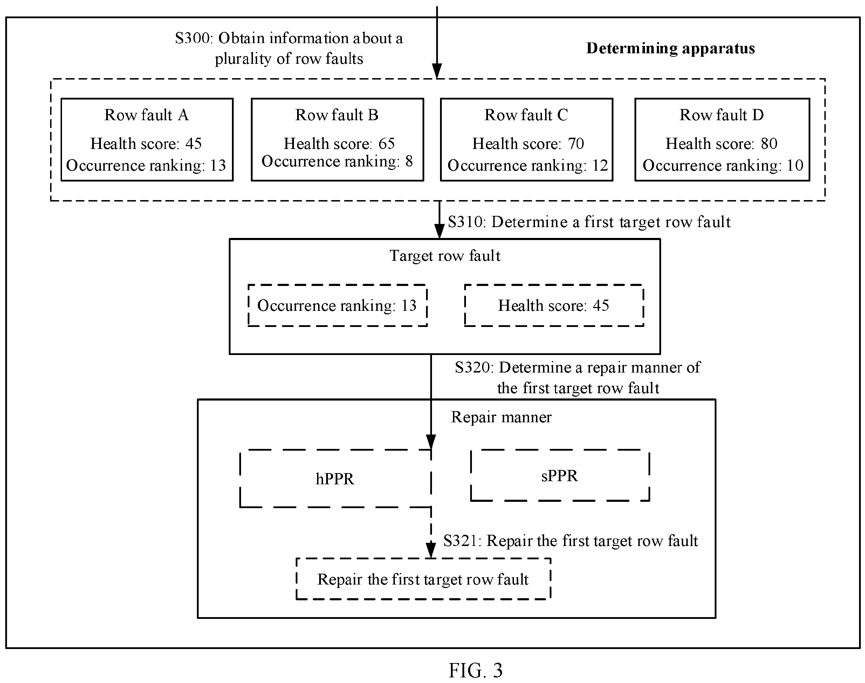

An embodiment of this application provides a method for determining a memory fault repair manner. As shown in FIG. 3, the method includes S300 to S320.

S300: a determining apparatus obtains information about a plurality of row faults.

It should be noted that the foregoing row fault is a CE fault or a UCE fault that occurs in a row (Row) in physical granularities of a memory.

Information about each row fault in the information about the plurality of row faults includes an occurrence ranking of the row fault and a health score of the row fault.

The occurrence ranking of the row fault is a quantity of row faults that occur on the memory within a target time period. The target time period is a time period from a last restart time of a server in which the memory is located to an occurrence time of the row fault. That is, the occurrence ranking of the row fault is an occurrence ranking of the row fault in a restart time interval (i.e., the ranking of the row fault in chronological order of occurrence in the restart time interval).

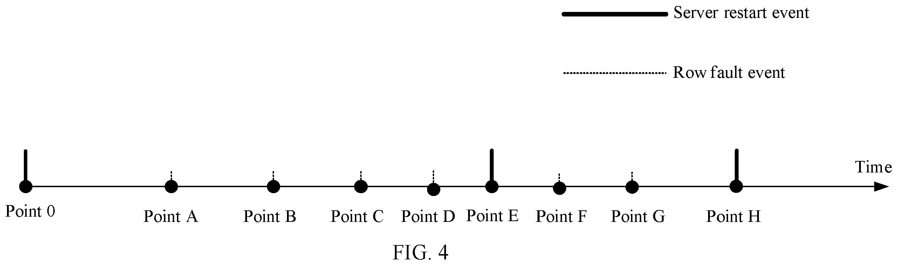

Exemplarily, as shown in FIG. 4, it is assumed that, in a restart time interval (point 0 to point E) of the server, the memory successively reports row faults A to D. In this case, an occurrence ranking of row fault A is a quantity of row faults that occur on the memory within a time period (a target time period) from point 0 to row fault point A, and only row fault A occurs on the memory within the target time period. Therefore, the determining apparatus can recognize only one row fault in the target time period, and the occurrence ranking of row fault A is 1.

It should be noted that the occurrence ranking of the row fault may be obtained by the determining apparatus through statistics collection, or may be obtained by the determining apparatus from another apparatus or device.

In a possible implementation, the occurrence ranking of the row fault may be obtained by the determining apparatus through statistics collection. For example, after a fault occurs, the determining apparatus may obtain information about the row fault from a BIOS. The information includes a time stamp of the occurrence of the row fault, and the determining apparatus may collect statistics about a row fault occurrence ranking in a restart time interval based on the time stamp.

In another possible implementation, the determining apparatus may directly obtain the occurrence ranking of the row fault from another apparatus or device. It should be noted that if the determining apparatus is a BMC, the another apparatus includes a processor, and if the determining apparatus is a processor, the another apparatus includes a BMC.

The health score of the row fault is obtained by inputting address information and quantities of Bit faults and/or Cell faults in the row fault into a scoring model.

It should be understood that each row fault in the memory is caused by a plurality of Bit faults and/or Cell faults. That is, when a quantity of Bit faults and/or Cell faults in the memory reaches a threshold, the memory reports a row fault.

The foregoing scoring model is used to assess a severity of a row fault and is obtained through training before step 400. Specifically, the scoring model may be a model obtained through training by using address information and quantities of Bit faults and/or Cell faults in information about a plurality of groups of row faults as training data. A label of each group of training data is a first health score of a row fault corresponding to the training data. The scoring model may be trained by using the processor 101 in the server 100, or may be trained by using another device, and then stored in the server 100, and used by the determining apparatus.

It should be noted that a specific implementation of the foregoing S300 may be: The determining apparatus actively obtains the information about the plurality of row faults from the another apparatus; or the another apparatus actively sends the information about the plurality of row faults to the determining apparatus. It should be noted that if the determining apparatus is the BMC, the another apparatus includes the processor. If the determining apparatus is the processor, the another apparatus includes the BMC. A specific manner of obtaining the information about the plurality of row faults is not limited in this embodiment of this application.

S310: the determining apparatus determines a first target row fault from the plurality of row faults based on a severity of each of the plurality of row faults.

The plurality of row faults are row faults occurring on the memory in a same restart time interval. The restart time interval is configured to indicate a time period from the last restart time of the server in which the memory is located to a current restart time of the server.

Exemplarily, as shown in FIG. 3, point 0 is a time at which the server restarts for the first time, and point E is a time at which the server restarts for the second time. Points A to D are four row faults that occur on the memory of the server after the first restart and before the second restart. The foregoing restart time interval indicates a time period from point 0 to point E. The plurality of row faults are row faults A to D corresponding to points A to D.

It should be noted that the foregoing S310 is specifically implemented in two implementations.

Manner 1: the determining apparatus randomly determines the first target row fault from the plurality of row faults.

The foregoing first target row fault is any row fault in the plurality of row faults. For example, as shown in FIG. 4, row faults A to D exist in one restart time interval, and the last row fault D is determined as the first target row fault.

Manner 2: the determining apparatus determines the first target row fault from the plurality of faults based on a severity of each of the plurality of row faults.

A health score may be used to identify a severity of a row fault, and the foregoing first target row fault is a row fault with a higher/highest severity (for example, the severity is greater than or equal to a first severity) in the plurality of row faults. That is, when a higher health score indicates a greater severity of the row fault, the first target row fault is a row fault with a higher health score/highest health score in the plurality of row faults. Alternatively, when a lower health score indicates a greater severity of the row fault, the first target row fault is a row fault with a lower/lowest health score in the plurality of row faults.

Exemplarily, it is assumed that the plurality of row faults are row faults A to D corresponding to points A to D in FIG. 4. A health score of row fault A is 30, a health score of row fault B is 40, a health score of row fault C is 60, and a health score of row fault D is 68. When a higher health score indicates a greater severity of the row fault, the determining apparatus determines row fault D with the highest health score as the first target row fault. Alternatively, when a lower health score indicates a greater severity of the row fault, the determining apparatus determines row fault A with the highest health score as the first target row fault.

It should be noted that there may be one or more first target row faults. A specific quantity of first target row faults is not limited in this embodiment of this application.

S320: the determining apparatus determines a repair manner of the first target row fault based on an occurrence ranking of the first target row fault and a severity of the first target row fault.

The foregoing repair manner of the first target row fault includes an hPPR manner or an sPPR manner.

When a health score of a row fault is used to represent a severity of the row fault, and a value corresponding to an occurrence ranking of the row fault is larger and a severity of the row fault is higher, a probability of repairing the row fault by using hPPR is higher.

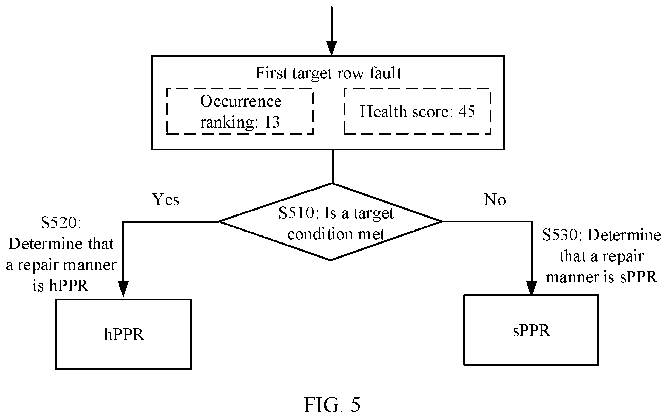

It should be noted that a specific implementation of the foregoing S320 is shown in FIG. 5 and includes (S510 and S520) or (S510 and S530).

S510: the determining apparatus determines, based on the occurrence ranking of the first target row fault and the severity of the first target row fault, whether the first target row fault meets a target condition.

The target condition is: the occurrence ranking of the first target row fault is greater than a quantity threshold, and the severity of the first target row fault is greater than a second severity; or the occurrence ranking of the first target row fault is equal to a quantity threshold, and the severity of the first target row fault is greater than a second severity; or the occurrence ranking of the first target row fault is greater than a quantity threshold, and the severity of the first target row fault is greater than or equal to a second severity.

The following two cases exist when the severity is identified by using a health score.

When a higher health score indicates a greater severity of the row fault, the foregoing target condition includes: the occurrence ranking of the first target row fault is greater than the quantity threshold, and a health score of the first target row fault is greater than a first health score; or the occurrence ranking of the first target row fault is equal to the quantity threshold, and a health score of the first target row fault is greater than a first health score; or the occurrence ranking of the first target row fault is greater than the quantity threshold, and a health score of the first target row fault is greater than or equal to the first health score.

When a lower health score indicates a greater severity of the row fault, the foregoing target condition includes: the occurrence ranking of the first target row fault is greater than the quantity threshold, and a health score of the first target row fault is less than a first health score; or the occurrence ranking of the first target row fault is equal to the quantity threshold, and a health score of the first target row fault is less than a first health score; or the occurrence ranking of the first target row fault is greater than the quantity threshold, and a health score of the first target row fault is less than or equal to a first health score.

S520: when the first target row fault meets the target condition, determine that the repair manner of the first target row fault includes hPPR.

S530: when the first target row fault does not meet the target condition, determine that the repair manner of the first target row fault includes sPPR.

It should be noted that, when the occurrence ranking of the first target row fault is equal to the quantity threshold and the severity of the first target row fault is equal to the second severity, the repair manner of the first target row fault may be hPPR, or may be sPPR.

Exemplarily, it is assumed that the quantity threshold is 3, and the first health score is 70. It is assumed that when the occurrence ranking of the first target row fault is 4 and the health score is 71, the repair manner of the first target row fault is hPPR. When the occurrence ranking of the first target row fault is 4 and the health score is 60, the repair manner of the first target row fault is sPPR.

Optionally, the foregoing target condition may alternatively be: the occurrence ranking of the first target row fault is less than a preset quantity threshold, or the severity of the first target row fault is lower than a severity corresponding to the first health score.

In this case, when the first target row fault meets the target condition, it is determined that the repair manner of the first target row fault includes sPPR. When the first target row fault does not meet the target condition, it is determined that the repair manner of the first target row fault includes hPPR.

It should be noted that a repair manner of any row fault in the plurality of row faults may be determined in the foregoing manner in S320.

It should be noted that the foregoing S320 may be executed after the determining apparatus receives the first target row fault, that is, after the determining apparatus receives a row fault, the determining apparatus determines a repair manner of the row fault. Alternatively, S320 may be executed by the determining apparatus when the server in which the memory is located restarts for the first time after the first target row fault occurs. A specific execution occasion of the foregoing S310 is not limited in this application.

Optionally, the determining apparatus needs to repair the first target row fault after determining the repair manner of the first target row fault. Specifically, S321 is included.

S321: the determining apparatus repairs the first target row fault according to the repair manner of the first target row fault.

It should be noted that a process of repairing the first target row fault according to the repair manner includes: replacing a faulty row in a storage area of the memory in which the first target row fault is located with an idle row in a redundant storage area of the memory. The idle row is a storage row Row that is in the redundant storage area of the memory and that is not used to replace a faulty row in the storage area.

When the repair manner is sPPR, the repair occasion (that is, an execution occasion of the foregoing S321) is a next restart time of the server in which the memory is located after the first target row fault occurs. When S320 is executed after the determining apparatus receives the first target row fault, S321 is executed at a time when the server restarts for the first time after the first target row fault occurs. After the repair, an effective time of sPPR starts from a moment at which sPPR is triggered, and lasts until the server restarts again.

Exemplarily, as shown in FIG. 4, in a time period from a time (that is, point 0) at which the server restarts for the first time to a time (that is, point E) at which the server restarts for the second time, four row fault events occur in storage of the server, which are respectively row faults A to D. If row fault C corresponding to point C is the first target row fault, and a repair manner of row fault C is sPPR, the determining apparatus triggers sPPR to repair the row fault when the server restarts for the second time (that is, point E). An effective time period of sPPR starts from a time at which the server restarts for the second time and ends at a time (that is, point H) at which the server restarts for the third time.

When the repair manner is hPPR, the repair occasion may be a next restart time of the server in which the memory is located after the first target row fault occurs. An effective time after the repair lasts permanently since hPPR is triggered.

It should be noted that the foregoing S321 is specifically implemented in the following manners.

In a first implementation, the determining apparatus replaces the first target row fault with an idle row in the redundant storage area of the memory according to the repair manner of the first target row fault. That is, the idle row in the redundant storage area of the memory is used to replace a faulty row indicated by an address of the first target row fault.

In a second implementation, the determining apparatus sends the repair manner of the first target row fault and the address of the first target row fault to another apparatus in the server, so that the another apparatus repairs the first target row fault according to the repair manner, for example, uses an idle row in the redundant storage area of the memory to replace the first target row fault according to the repair manner of the first target row fault. It should be noted that if the determining apparatus is a BMC, the another apparatus includes a processor, and if the determining apparatus is a processor, the another apparatus includes a BMC.

It should be understood that the address of the first target row fault is used by the target apparatus to determine, based on the address, the faulty row in which the first target row fault is located.

In the method for determining a memory fault repair manner provided in this embodiment of this application, the repair manner of the first target row fault is determined based on the occurrence ranking of the first target row fault and the health score of the first target row fault. The health score of the first target row fault is used to represent the severity of the first target row fault. Subsequently, the first target row fault is repaired according to the determined repair manner. Compared with a conventional manner of repairing the first target row fault according to preset sPPR or hPPR, the solution in this embodiment of this application can adaptively select a PPR repair manner based on the occurrence ranking of the first target row fault and the severity of the first target row fault. Therefore, a problem of resource waste in the redundant storage area of the memory and a problem of reduced memory reliability caused by an inconsistency between a repair manner actually required for a row fault and a preset repair manner in the conventional preset manner are resolved.

In addition, when the manner of determining the first target row fault is manner 2 in S310, compared with the conventional manner of repairing the last row fault in a restart time interval, this embodiment of this application is to determine a row fault with a higher severity in the plurality of row faults as the first target row fault based on respective health scores of the plurality of row faults, and then repair the first target row fault with the higher severity. In this way, a case in which a row fault with a lower severity is repaired but a row fault with a higher severity is ignored is avoided. Therefore, memory stability is improved, and a probability of service interruption is reduced.

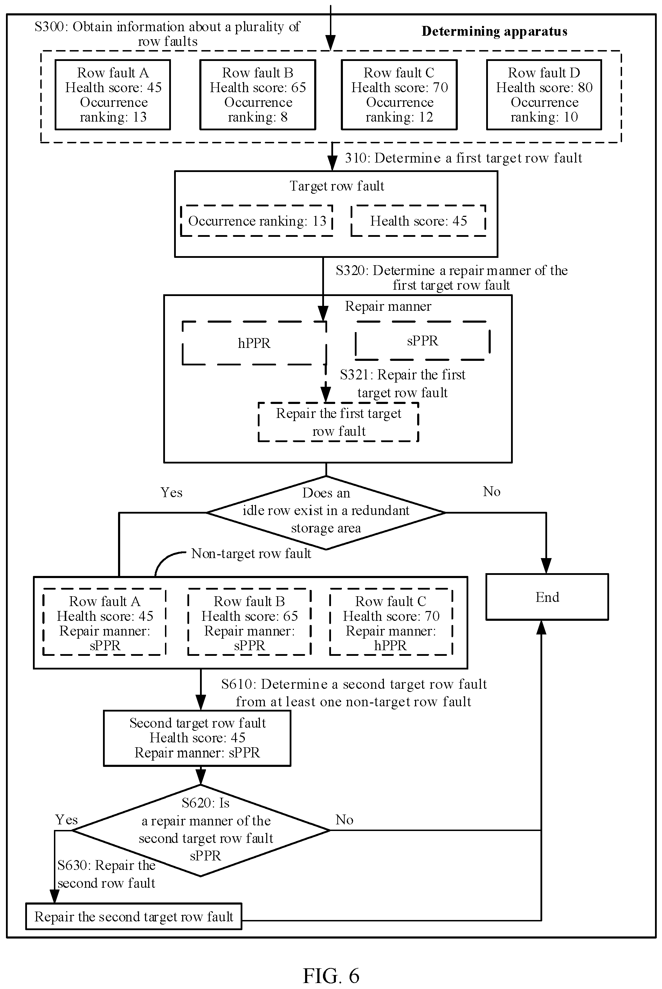

Optionally, with reference to FIG. 3, as shown in FIG. 6, after the determining apparatus completes execution of S310 or S321, if there is an idle row in the redundant storage area of the memory, the determining apparatus performs S610 to S630. If there is no idle row in the redundant storage area of the memory, the determining apparatus ends executing the method.

S610: the determining apparatus determines a second target row fault from at least one non-target row fault based on a severity of each of the at least one non-target row fault.

It should be noted that a non-target row fault is a row fault in a restart time interval other than the first target row fault determined in the foregoing S310. The foregoing at least one non-target row fault is a non-target row fault that occurs on the memory in a restart time interval.

A severity of the second target row fault is higher than a third severity, and the severity of the second target row fault is lower than the severity of the first target row fault.

S620: the determining apparatus determines whether a repair manner of the second target row fault is sPPR.

A method for determining the repair manner of the second target row fault includes the following manners.

In a first implementation, a repair manner is preset for each non-target row fault, and the second target row fault is one of the non-target row faults. Therefore, the repair manner of the second target row fault is preset. Alternatively, a repair manner is preset for the second target row fault after the second target row fault is determined.

In a second implementation, the repair manner is determined based on an occurrence ranking of the second target row fault and a health score of the second target row fault. A specific determining manner is similar to that of the foregoing S320, and details are not described herein again.

Exemplarily, points A to D in FIG. 4 correspond to row faults A to D. A health score of row fault A is 30, and a repair manner of the row fault A is sPPR. A health score of row fault B is 40, and a repair manner of row fault B is sPPR. A health score of row fault C is 65, and a repair manner of row fault C is sPPR. A health score of row fault D is 78, and a repair manner of row fault D is hPPR. A health score corresponding to a preset severity B is 60. When a higher health score indicates a greater severity of the row fault, the first target row fault is row fault D. After the first target row fault is handled, the determining apparatus determines, from the three non-target row faults (that is, row faults A to C), row fault C whose health score is greater than 60 and whose row fault repair manner is sPPR as a to-be-handled row fault.

When the repair manner of the second target row fault is sPPR, the following S630 is performed.

It may be understood that, the repair manner of the second target row fault is sPPR because an effective time of sPPR is one restart time interval, and after the first restart time interval ends, a Row in the redundant storage space that replaces the faulty row in the sPPR manner is released. When a row fault with a relatively high severity exists in a next restart time interval, the idle row is used to replace the faulty row.

When the repair manner of the second target row fault is hPPR, the method ends.

S630: the determining apparatus repairs the second target row fault according to the repair manner of the second target row fault.

It may be understood that, because repair occasions of both hPPR and sPPR in an existing PPR technology are a time at which a restart occurs for the first time on the server in which the memory is located after a row fault occurs, an execution occasion of the foregoing S630 is the time at which the restart occurs for the first time on the server in which the memory is located after the second target row fault occurs.

It should be noted that an implementation of the foregoing S630 is similar to the implementation of S321. For specific description of S630, refer to the foregoing related description of S321. Details are not described herein again.

Compared with the conventional manner that only the first target row fault is repaired, in the method for determining a memory fault repair manner provided in this embodiment of this application, after the first target row fault is repaired, if there is an idle row in the redundant storage area of the memory, the determining apparatus determines, from at least one non-target row fault, a second target row fault whose severity is relatively high and whose repair manner is sPPR, and repairs the second target row fault, so that utilization of the redundant storage area is improved, and memory reliability is improved.

Correspondingly, an embodiment of this application provides a determining apparatus. The determining apparatus is configured to perform the steps in the foregoing method for determining a memory fault repair manner. In this embodiment of this application, functional module division may be performed on the determining apparatus according to the foregoing method example. For example, functional modules may be obtained through division based on corresponding functions, or two or more functions may be integrated into one processing module. The foregoing integrated module may be implemented in a form of hardware, or may be implemented in a form of a software functional module. Module division in embodiments of this application is an example, and is merely logical function division. In an actual implementation, there may be another division manner.

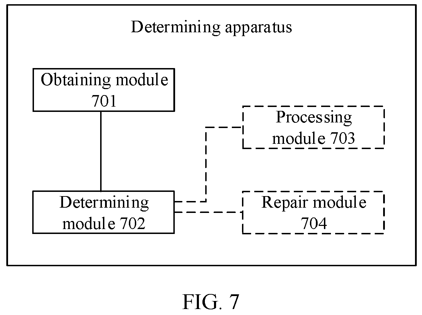

In a case in which the functional modules are obtained through division based on corresponding functions, FIG. 7 is a schematic diagram of a possible structure of the determining apparatus in the foregoing embodiment. As shown in FIG. 7, the determining apparatus includes an obtaining module 701 and a determining module 702.

The obtaining module 701 is configured to obtain information about a plurality of row faults, for example, perform step S300 in the foregoing method embodiment.

The determining module 702 is configured to determine a first target row fault from the plurality of row faults based on a severity of each of the plurality of row faults, for example, perform step S310 in the foregoing method embodiment.

The determining module 702 is further configured to determine a repair manner of the first target row fault based on an occurrence ranking of the first target row fault and a severity of the first target row fault, for example, perform step S320 in the foregoing method embodiment.

Optionally, the determining apparatus further includes a processing module 703.

The processing module 703 is configured to input address information and quantities of Bit faults and/or Cell faults in the row faults that are included in the information about the plurality of row faults into a scoring model, to obtain the severities of the plurality of row faults.

Optionally, the determining module 702 is configured to determine the first target row fault from the plurality of row faults based on the severity of each of the plurality of row faults.

Optionally, the determining apparatus further includes a repair module 704.

The determining module 702 is configured to determine a second target row fault from at least one non-target row fault based on a severity of each of the at least one non-target row fault, for example, perform step S320 in the foregoing method embodiment.

The repair module 704 is configured to repair the second target row fault according to a repair manner of the second target row fault, for example, perform step S630 in the foregoing method embodiment.

Each module of the determining apparatus may be further configured to perform another action in the foregoing method embodiment. All related content of each step in the foregoing method embodiment may be referenced to a function description of a corresponding functional module, and details are not described herein again.

Some or all of the steps of the obtaining module 701, the determining module 702, the processing module 703, and the repairing module 704 may be implemented by the processor 101 in FIG. 1 by executing code in the storage 102.

All or some of the foregoing embodiments may be implemented by using software, hardware, firmware, or any combination thereof. When a software program is used to implement the embodiments, all or some of the embodiments may be implemented in a form of a computer program product. The computer program product includes one or more computer instructions. When the computer instructions are loaded and executed on a computer, the procedures or functions described in embodiments of this application are completely or partially generated. The computer may be a general-purpose computer, a dedicated computer, a computer network, or other programmable apparatuses. The computer instructions may be stored in a computer-readable storage medium or transmitted from one computer-readable storage medium to another computer-readable storage medium. For example, the computer instructions may be transmitted from one website, computer, server, or data center to another website, computer, server, or data center in a wired (for example, a coaxial cable, an optical fiber, or a digital subscriber line (digital subscriber line, DSL)) or wireless (for example, infrared, wireless, or microwave) manner. The computer-readable storage medium may be any available medium accessible by the computer or a data storage device that includes one or more available media, for example, a server or a data center. The available medium may be a magnetic medium (for example, a floppy disk, a magnetic disk, or a magnetic tape), an optical medium (for example, a digital video disc (digital video disc, DVD)), or a semiconductor medium (for example, solid state drives (solid state drives, SSD)).

According to the foregoing descriptions of the implementations, a person skilled in the art may clearly understand that, for ease and brevity of description, division of the foregoing functional modules is merely used as an example for description. In actual application, the foregoing functions may be allocated to different functional modules as required, that is, an internal structure of an apparatus is divided into different functional modules, to complete all or some of the foregoing functions. For a specific working process of the foregoing system, apparatus, and unit, refer to a corresponding process in the foregoing method embodiment. Details are not described herein again.

In the several embodiments provided in this application, it should be understood that the disclosed system, apparatus, and method may be implemented in another manner. For example, the foregoing apparatus embodiment is merely an example. For example, division of the modules or units is merely logical function division. In an actual implementation, there may be another division manner. For example, a plurality of units or components may be combined or integrated into another system, or some features may be ignored or not performed. In addition, displayed or discussed mutual couplings or direct couplings or communication connections may be implemented through some interfaces, and indirect couplings or communication connections between apparatuses or units may be implemented in an electrical form, a mechanical form, or another form.

The units described as separate parts may or may not be physically separate, and parts displayed as units may or may not be physical units, may be located in one location, or may be distributed on a plurality of network units. Some or all of the units may be selected based on an actual requirement to implement the objectives of the solutions in embodiments.

In addition, functional units in embodiments of this application may be integrated into one processing unit, or each unit may exist separately physically, or two or more units may be integrated into one unit. The foregoing integrated unit may be implemented in a form of hardware, or may be implemented in a form of a software functional unit.

If the integrated unit is implemented in a form of a software functional unit and sold or used as an independent product, the integrated unit may be stored in a computer-readable storage medium. Based on such an understanding, the technical solutions of this application essentially, or the part contributing to the conventional technology, or all or some of the technical solutions may be implemented in a form of a software product. The computer software product is stored in a storage medium and includes several instructions for instructing a computer device (which may be a personal computer, a server, a network device, or the like) or a processor to perform all or some of the steps of the methods described in the embodiments of this application. The foregoing storage medium includes any medium that can store program code, such as a flash memory, a removable hard disk, a read-only memory, a random access memory, a magnetic disk, or an optical disc.

The foregoing descriptions are merely specific implementations of this application, but are not intended to limit the protection scope of this application. Any change or replacement made within the technical scope disclosed in this application shall fall within the protection scope of this application. Therefore, the protection scope of this application shall be subject to the protection scope of the claims.

## Claims

1. A method for determining a memory fault repair manner, wherein the method comprises:
obtaining (S300) information about a plurality of row faults, wherein information about a row fault comprises an occurrence ranking of the row fault and a severity of the row fault, the occurrence ranking of the row fault is a quantity of row faults occurring on the memory within a target time period, and the target time period is a time period from a last restart time of a server in which the memory is located to an occurrence time of the row fault;
determining (S310) a first target row fault from the plurality of row faults based on a severity of each of the plurality of row faults; and
determining (S320) a repair manner of the first target row fault based on an occurrence ranking of the first target row fault and a severity of the first target row fault;
wherein the determining a repair manner of the first target row fault based on an occurrence ranking of the first target row fault and a severity of the first target row fault comprises:
when the occurrence ranking of the first target row fault is greater than a quantity threshold and the severity of the first target row fault is greater than a second severity, or when the occurrence ranking of the first target row fault is equal to a quantity threshold and the severity of the first target row fault is greater than a second severity, or when the occurrence ranking of the first target row fault is greater than a quantity threshold and the severity of the first target row fault is greater than or equal to a second severity,
the repair manner of the first target row fault is a hardware post-package repair method;
when the occurrence ranking of the first target row fault is equal to a quantity threshold and the severity of the first target row fault is equal to a second severity, the repair manner of the first target row fault is one of a hardware post-package repair method or a soft post-package repair method;
otherwise, the repair manner of the first target row fault is a soft post-package repair method;
wherein the information about the plurality of row faults further comprises address information and quantities of Bit faults and/or Cell faults in the row faults, and the method further comprises: inputting the address information and the quantities into a scoring model to obtain the severities of the plurality of row faults, wherein the scoring model is configured to assess a severity of a row fault.

2. The method according to claim 1, wherein information about a row fault specifically comprises an occurrence ranking of the row fault and a health score of the row fault, and the health score is configured to identify a severity of the row fault.

3. The method according to claim 1 or 2, wherein the determining a first target row fault from the plurality of row faults comprises:
determining the first target row fault from the plurality of row faults based on the severity of each of the plurality of row faults, wherein the plurality of row faults are row faults that occur on the memory in a same restart time interval, the restart time interval is configured to indicate a time period from the last restart time of the server to a current restart time of the server, and the severity of the first target row fault is greater than or equal to a first severity.

4. The method according to any one of claims 1 to 3, wherein the method further comprises:
when there is an idle row in a redundant storage area in the memory, determining a second target row fault from at least one non-target row fault based on a severity of each of the at least one non-target row fault, wherein the at least one non-target row fault is a non-target row fault that occurs on the memory in a same restart time interval, a severity of the second target row fault is greater than or equal to a third severity, and a repair manner of the second target row fault is a soft post-package repair manner; and
repairing the second target row fault according to the repair manner of the second target row fault.

5. A determining apparatus, wherein the determining apparatus comprises an obtaining module (701) and a determining module (702);
the obtaining module (701) is configured to obtain information about a plurality of row faults, wherein information about a row fault comprises an occurrence ranking of the row fault and a severity of the row fault, the occurrence ranking of the row fault is a quantity of row faults occurring on a memory within a target time period, and the target time period is a time period from a last restart time of a server in which the memory is located to an occurrence time of the row fault;
the determining module (702) is configured to determine a first target row fault from the plurality of row faults based on a severity of each of the plurality of row faults; and
the determining module (702) is further configured to determine a repair manner of the first target row fault based on an occurrence ranking of the first target row fault and a severity of the first target row fault; wherein
when the occurrence ranking of the first target row fault is greater than a quantity threshold and the severity of the first target row fault is greater than a second severity, or when the occurrence ranking of the first target row fault is equal to a quantity threshold and the severity of the first target row fault is greater than a second severity, or when the occurrence ranking of the first target row fault is greater than a quantity threshold and the severity of the first target row fault is greater than or equal to a second severity,
the repair manner of the first target row fault is a hardware post-package repair method;
when the occurrence ranking of the first target row fault is equal to a quantity threshold and the severity of the first target row fault is equal to a second severity,
the repair manner of the first target row fault is one of a hardware post-package repair method or a soft post-package repair method;
otherwise, the repair manner of the first target row fault is a soft post-package repair method;
wherein the determining apparatus further comprises a processing module, wherein the processing module (703) is configured to input address information and quantities of Bit faults and/or Cell faults in the row faults that are comprised in the information about the plurality of row faults into a scoring model, to obtain the severities of the plurality of row faults, wherein the scoring model is configured to assess a severity of a row fault.

6. The determining apparatus according to claim 5, wherein
information about a row fault specifically comprises an occurrence ranking of the row fault and a health score of the row fault, and the health score is configured to identify a severity of the row fault.

7. The determining apparatus according to claim 5 or 6, wherein
the determining module (702) is configured to determine the first target row fault from the plurality of row faults based on the severity of each of the plurality of row faults, wherein the plurality of row faults are row faults that occur on the memory in a same restart time interval, the restart time interval is configured to indicate a time period from the last restart time of the server to a current restart time of the server, and the severity of the first target row fault is greater than or equal to a first severity.

8. The determining apparatus according to any one of claims 5 to 7, wherein the determining apparatus further comprises a repair module (704);
the determining module (702) is configured to: when there is an idle row in a redundant storage area in the memory, determine a second target row fault from at least one non-target row fault based on a severity of each of the at least one non-target row fault, wherein the at least one non-target row fault is a non-target row fault that occurs on the memory in a same restart time interval, a severity of the second target row fault is greater than or equal to a third severity, and a repair manner of the second target row fault is a soft post-package repair manner; and
the repair module (704) is configured to repair the second target row fault according to the repair manner of the second target row fault.

9. A computing device, comprising a storage and a processor, wherein the storage is coupled to the processor, the storage is configured to store computer program code, the computer program code comprises computer instructions, and when the computer instructions are executed by the processor, the processor is enabled to perform the method according to any one of claims 1 to 4.

10. A server, comprising a storage (102), a processor (101), and a BMC, wherein the BMC is configured to perform the method according to any one of claims 1 to 4.

11. A server, comprising a storage (102), a processor (101), and a BMC, wherein the processor (101) is configured to perform the method according to any one of claims 1 to 4.

## Patentansprüche

1. Verfahren zur Bestimmung einer Speicherfehlerreparaturweise, wobei das Verfahren Folgendes umfasst:
Erhalten (S300)
von Informationen über eine Vielzahl von Zeilenfehlern, wobei die Informationen über einen Zeilenfehler einen Auftrittsrang des Zeilenfehlers und einen Schweregrad des Zeilenfehlers umfassen, der Auftrittsrang des Zeilenfehlers eine Menge von Zeilenfehlern ist, die innerhalb eines Zielzeitraums in dem Speicher auftreten, und der Zielzeitraum ein Zeitraum von einem letzten Neustartzeitpunkt eines Servers, in dem sich der Speicher befindet, bis zu einem Auftrittszeitpunkt des Zeilenfehlers ist;
Bestimmen (S310)
eines ersten Zielzeilenfehlers aus der Vielzahl von Zeilenfehlern basierend auf einem Schweregrad jedes der Vielzahl von Zeilenfehlern; und
Bestimmen (S320)
einer Reparaturweise des ersten Zielzeilenfehlers basierend auf einem Auftrittsrang des ersten Zielzeilenfehlers und einem Schweregrad des ersten Zielzeilenfehlers;
wobei das Bestimmen einer Reparaturweise des ersten Zielzeilenfehlers basierend auf einem Auftrittsrang des ersten Zielzeilenfehlers und einem Schweregrad des ersten Zielzeilenfehlers Folgendes umfasst:
wenn der Auftrittsrang des ersten Zielzeilenfehlers größer als ein Mengenschwellenwert ist und der Schweregrad des ersten Zielzeilenfehlers größer als ein zweiter Schweregrad ist oder wenn der Auftrittsrang des ersten Zielzeilenfehlers gleich einem Mengenschwellenwert ist und der Schweregrad des ersten Zielzeilenfehlers größer als ein zweiter Schweregrad ist oder wenn der Auftrittsrang des ersten Zielzeilenfehlers größer als ein Mengenschwellenwert ist und der Schweregrad des ersten Zielzeilenfehlers größer als oder gleich einem zweiten Schweregrad ist,
die Reparaturweise des ersten Zielzeilenfehlers ein Hardware-Post-Package-Reparaturverfahren ist;
wenn der Auftrittsrang des ersten Zielzeilenfehlers gleich einem Mengenschwellenwert ist und der Schweregrad des ersten Zielzeilenfehlers gleich einem zweiten Schweregrad ist, die Reparaturweise des ersten Zielzeilenfehlers eines von einem Hardware-Post-Package-Reparaturverfahren oder einem Soft-Post-Package-Reparaturverfahren ist;
die Reparaturweise des ersten Zielzeilenfehlers andernfalls ein Soft-Post-Package-Reparaturverfahren ist;
wobei die Informationen über die Vielzahl von Zeilenfehlern ferner Adressinformationen und Mengen von Bitfehlern und/oder Zellenfehlern in den Zeilenfehlern umfassen und das Verfahren ferner Folgendes umfasst: Eingeben der Adressinformationen und der Mengen in ein Bewertungsmodell, um die Schweregrade der Vielzahl von Zeilenfehlern zu erhalten, wobei das Bewertungsmodell konfiguriert ist, einen Schweregrad eines Zeilenfehlers zu beurteilen.

2. Verfahren nach Anspruch 1, wobei die Informationen über einen Zeilenfehler insbesondere einen Auftrittsrang des Zeilenfehlers und eine Zustandsbewertung des Zeilenfehlers umfassen und die Zustandsbewertung konfiguriert ist, einen Schweregrad des Zeilenfehlers zu identifizieren.

3. Verfahren nach Anspruch 1 oder 2, wobei das Bestimmen eines ersten Zielzeilenfehlers aus der Vielzahl von Zeilenfehlern Folgendes umfasst:
Bestimmen des ersten Zielzeilenfehlers aus der Vielzahl von Zeilenfehlern basierend auf dem Schweregrad jedes der Vielzahl von Zeilenfehlern, wobei die Vielzahl von Zeilenfehlern Zeilenfehler sind, die in dem Speicher in einem gleichen Neustartzeitintervall auftreten, das Neustartzeitintervall konfiguriert ist, einen Zeitraum von dem letzten Neustartzeitpunkt des Servers bis zu einem aktuellen Neustartzeitpunkt des Servers anzugeben, und der Schweregrad des ersten Zielzeilenfehlers größer als oder gleich einem ersten Schweregrad ist.

4. Verfahren nach einem der Ansprüche 1 bis 3, wobei das Verfahren ferner Folgendes umfasst:
wenn es eine Leerzeile in einem redundanten Speicherbereich in dem Speicher gibt, Bestimmen eines zweiten Zielzeilenfehlers aus mindestens einem Nicht-Zielzeilenfehler basierend auf einem Schweregrad jedes des mindestens einen Nicht-Zielzeilenfehlers, wobei der mindestens eine Nicht-Zielzeilenfehler ein Nicht-Zielzeilenfehler ist, der in dem Speicher in einem gleichen Neustartzeitintervall auftritt, ein Schweregrad des zweiten Zielzeilenfehlers größer als oder gleich einem dritten Schweregrad ist und eine Reparaturweise des zweiten Zielzeilenfehlers eine Soft-Post-Package-Reparaturweise ist; und
Reparieren des zweiten Zielzeilenfehlers gemäß der Reparaturweise des zweiten Zielzeilenfehlers.

5. Bestimmungsvorrichtung, wobei die Bestimmungsvorrichtung ein Erhaltemodul (701) und ein Bestimmungsmodul (702) umfasst;
das Erhaltemodul (701) konfiguriert ist, Informationen über eine Vielzahl von Zeilenfehlern zu erhalten, wobei die Informationen über einen Zeilenfehler einen Auftrittsrang des Zeilenfehlers und einen Schweregrad des Zeilenfehlers umfassen, der Auftrittsrang des Zeilenfehlers eine Menge von Zeilenfehlern ist, die innerhalb eines Zielzeitraums in einem Speicher auftreten, und der Zielzeitraum ein Zeitraum von einem letzten Neustartzeitpunkt eines Servers, in dem sich der Speicher befindet, bis zu einem Auftrittszeitpunkt des Zeilenfehlers ist;
das Bestimmungsmodul (702) konfiguriert ist, einen ersten Zielzeilenfehler aus der Vielzahl von Zeilenfehlern basierend auf einem Schweregrad jedes der Vielzahl von Zeilenfehlern zu bestimmen; und
das Bestimmungsmodul (702) ferner konfiguriert ist, eine Reparaturweise des ersten Zielzeilenfehlers basierend auf einem Auftrittsrang des ersten Zielzeilenfehlers und einem Schweregrad des ersten Zielzeilenfehlers zu bestimmen; wobei,
wenn der Auftrittsrang des ersten Zielzeilenfehlers größer als ein Mengenschwellenwert ist und der Schweregrad des ersten Zielzeilenfehlers größer als ein zweiter Schweregrad ist oder wenn der Auftrittsrang des ersten Zielzeilenfehlers gleich einem Mengenschwellenwert ist und der Schweregrad des ersten Zielzeilenfehlers größer als ein zweiter Schweregrad ist oder wenn der Auftrittsrang des ersten Zielzeilenfehlers größer als ein Mengenschwellenwert ist und der Schweregrad des ersten Zielzeilenfehlers größer als oder gleich einem zweiten Schweregrad ist,
die Reparaturweise des ersten Zielzeilenfehlers ein Hardware-Post-Package-Reparaturverfahren ist;
wenn der Auftrittsrang des ersten Zielzeilenfehlers gleich einem Mengenschwellenwert ist und der Schweregrad des ersten Zielzeilenfehlers gleich einem zweiten Schweregrad ist,
die Reparaturweise des ersten Zielzeilenfehlers eines von einem Hardware-Post-Package-Reparaturverfahren oder einem Soft-Post-Package-Reparaturverfahren ist;
die Reparaturweise des ersten Zielzeilenfehlers andernfalls ein Soft-Post-Package-Reparaturverfahren ist;
wobei die Bestimmungsvorrichtung ferner ein Verarbeitungsmodul umfasst, wobei das Verarbeitungsmodul (703) konfiguriert ist, Adressinformationen und Mengen von Bitfehlern und/oder Zellenfehlern in den Zeilenfehlern, die in den Informationen über die Vielzahl von Zeilenfehlern enthalten sind, in ein Bewertungsmodell einzugeben, um die Schweregrade der Vielzahl von Zeilenfehlern zu erhalten, wobei das Bewertungsmodell konfiguriert ist, einen Schweregrad eines Zeilenfehlers zu beurteilen.

6. Bestimmungsvorrichtung nach Anspruch 5, wobei die Informationen über einen Zeilenfehler insbesondere einen Auftrittsrang des Zeilenfehlers und eine Zustandsbewertung des Zeilenfehlers umfassen und die Zustandsbewertung konfiguriert ist, einen Schweregrad des Zeilenfehlers zu identifizieren.

7. Bestimmungsvorrichtung nach Anspruch 5 oder 6, wobei das Bestimmungsmodul (702) konfiguriert ist, den ersten Zielzeilenfehler aus der Vielzahl von Zeilenfehlern basierend auf dem Schweregrad jedes der Vielzahl von Zeilenfehlern zu bestimmen, wobei die Vielzahl von Zeilenfehlern Zeilenfehler sind, die in dem Speicher in einem gleichen Neustartzeitintervall auftreten, das Neustartzeitintervall konfiguriert ist, einen Zeitraum von dem letzten Neustartzeitpunkt des Servers bis zu einem aktuellen Neustartzeitpunkt des Servers anzugeben, und der Schweregrad des ersten Zielzeilenfehlers größer als oder gleich einem ersten Schweregrad ist.

8. Bestimmungsvorrichtung nach einem der Ansprüche 5 bis 7, wobei die Bestimmungsvorrichtung ferner ein Reparaturmodul (704) umfasst;
das Bestimmungsmodul (702) zu Folgendem konfiguriert ist: wenn es eine Leerzeile in einem redundanten Speicherbereich in dem Speicher gibt, Bestimmen eines zweiten Zielzeilenfehlers aus mindestens einem Nicht-Zielzeilenfehler basierend auf einem Schweregrad jedes des mindestens einen Nicht-Zielzeilenfehlers, wobei der mindestens eine Nicht-Zielzeilenfehler ein Nicht-Zielzeilenfehler ist, der in dem Speicher in einem gleichen Neustartzeitintervall auftritt, ein Schweregrad des zweiten Zielzeilenfehlers größer als oder gleich einem dritten Schweregrad ist und eine Reparaturweise des zweiten Zielzeilenfehlers eine Soft-Post-Package-Reparaturweise ist; und
das Reparaturmodul (704) konfiguriert ist, den zweiten Zielzeilenfehler gemäß der Reparaturweise des zweiten Zielzeilenfehlers zu reparieren.

9. Recheneinrichtung, umfassend einen Speicher und einen Prozessor, wobei der Speicher mit dem Prozessor gekoppelt ist, der Speicher konfiguriert ist, einen Computerprogrammcode zu speichern, der Computerprogrammcode Computeranweisungen umfasst und, wenn die Computeranweisungen durch den Prozessor ausgeführt werden, der Prozessor in die Lage versetzt wird, das Verfahren nach einem der Ansprüche 1 bis 4 durchzuführen.

10. Server, umfassend einen Speicher (102), einen Prozessor (101) und einen BMC, wobei der BMC konfiguriert ist, das Verfahren nach einem der Ansprüche 1 bis 4 durchzuführen.

11. Server, umfassend einen Speicher (102), einen Prozessor (101) und einen BMC, wobei der Prozessor (101) konfiguriert ist, das Verfahren nach einem der Ansprüche 1 bis 4 durchzuführen.

## Revendications

1. Procédé de détermination d'un mode de réparation de défaillance de mémoire, dans lequel le procédé comprend :
l'obtention (S300) d'informations concernant une pluralité de défaillances de ligne, dans lequel des informations concernant une défaillance de ligne comprennent un classement d'occurrence de la défaillance de ligne et une gravité de la défaillance de ligne, le classement d'occurrence de la défaillance de ligne est une quantité de défaillances de ligne survenant sur la mémoire au cours d'une période de temps cible, et la période de temps cible est une période de temps allant du dernier temps de redémarrage d'un serveur dans lequel la mémoire est située au temps d'occurrence de la défaillance de ligne ;
la détermination (S310) d'une première défaillance de ligne cible à partir de la pluralité de défaillances de ligne sur la base d'une gravité de chacune de la pluralité de défaillances de ligne ; et
la détermination (S320) d'un mode de réparation de la première défaillance de ligne cible sur la base d'un classement d'occurrence de la première défaillance de ligne cible et d'une gravité de la première défaillance de ligne cible ;
dans lequel la détermination d'un mode de réparation de la première défaillance de ligne cible sur la base d'un classement d'occurrence de la première défaillance de ligne cible et d'une gravité de la première défaillance de ligne cible comprend :
lorsque le classement d'occurrence de la première défaillance de ligne cible est supérieur à un seuil de quantité et que la gravité de la première défaillance de ligne cible est supérieure à une deuxième gravité, ou lorsque le classement d'occurrence de la première défaillance de ligne cible est égal à un seuil de quantité et que la gravité de la première défaillance de ligne cible est supérieure à une deuxième gravité, ou lorsque le classement d'occurrence de la première défaillance de ligne cible est supérieur à un seuil de quantité et que la gravité de la première défaillance de ligne cible est supérieure ou égale à une deuxième gravité,
le mode de réparation de la première défaillance de ligne cible est un procédé de réparation matérielle post-emballage ;
lorsque le classement d'occurrence de la première défaillance de ligne cible est égal à un seuil de quantité et que la gravité de la première défaillance de ligne cible est égale à une deuxième gravité, le mode de réparation de la première défaillance de ligne cible est l'un d'un procédé de réparation matérielle post-assemblage ou d'un procédé de réparation logicielle post-assemblage ;
autrement, le mode de réparation de la première défaillance de ligne cible est un procédé de réparation logicielle post-emballage ;
dans lequel les informations concernant la pluralité de défaillances de ligne comprennent en outre des informations d'adresse et des quantités de défaillances de bits et/ou de défaillances de cellules dans les défaillances de ligne, et le procédé comprend en outre : l'entrée des informations d'adresse et des quantités dans un modèle de notation pour obtenir les gravités de la pluralité de défaillances de ligne, dans lequel le modèle de notation est configuré pour évaluer une gravité d'une défaillance de ligne.

2. Procédé selon la revendication 1, dans lequel des informations concernant une défaillance de ligne comprennent spécifiquement un classement d'occurrence de la défaillance de ligne et un score de santé de la défaillance de ligne, et le score de santé est configuré pour identifier une gravité de la défaillance de ligne.

3. Procédé selon la revendication 1 ou 2, dans lequel la détermination d'une première défaillance de ligne cible à partir de la pluralité de défaillances de ligne comprend :
la détermination de la première défaillance de ligne cible à partir de la pluralité de défaillances de ligne sur la base de la gravité de chacune de la pluralité de défaillances de ligne, dans lequel la pluralité de défaillances de ligne sont des défaillances de ligne qui surviennent sur la mémoire dans un même intervalle de temps de redémarrage, l'intervalle de temps de redémarrage est configuré pour indiquer une période de temps allant du dernier temps de redémarrage du serveur à un temps de redémarrage actuel du serveur, et la gravité de la première défaillance de ligne cible est supérieure ou égale à une première gravité.

4. Procédé selon l'une quelconque des revendications 1 à 3, dans lequel le procédé comprend en outre :
lorsqu'il y a une ligne inactive dans une zone de stockage redondante dans la mémoire, la détermination d'une seconde défaillance de ligne cible à partir d'au moins une défaillance de ligne non cible sur la base d'une gravité de chacune de l'au moins une défaillance de ligne non cible, dans lequel l'au moins une défaillance de ligne non cible est une défaillance de ligne non cible qui survient sur la mémoire dans un même intervalle de temps de redémarrage, une gravité de la seconde défaillance de ligne cible est supérieure ou égale à une troisième gravité et un mode de réparation de la seconde défaillance de ligne cible est un mode de réparation logicielle post-emballage ; et
la réparation de la seconde défaillance de ligne cible selon le mode de réparation de la seconde défaillance de ligne cible.

5. Appareil de détermination, dans lequel l'appareil de détermination comprend un module d'obtention (701) et un module de détermination (702) ;
le module d'obtention (701) est configuré pour obtenir des d'informations concernant une pluralité de défaillances de ligne, dans lequel des informations concernant une défaillance de ligne comprennent un classement d'occurrence de la défaillance de ligne et une gravité de la défaillance de ligne, le classement d'occurrence de la défaillance de ligne est une quantité de défaillances de ligne survenant sur une mémoire au cours d'une période de temps cible, et la période de temps cible est une période de temps allant du dernier temps de redémarrage d'un serveur dans lequel la mémoire est située au temps d'occurrence de la défaillance de ligne ;
le module de détermination (702) est configuré pour déterminer une première défaillance de ligne cible à partir de la pluralité de défaillances de ligne sur la base d'une gravité de chacune de la pluralité de défaillances de ligne ; et
le module de détermination (702) est en outre configuré pour déterminer un mode de réparation de la première défaillance de ligne cible sur la base d'un classement d'occurrence de la première défaillance de ligne cible et d'une gravité de ladite première défaillance de ligne cible ; dans lequel
lorsque le classement d'occurrence de la première défaillance de ligne cible est supérieur à un seuil de quantité et que la gravité de la première défaillance de ligne cible est supérieure à une deuxième gravité, ou lorsque le classement d'occurrence de la première défaillance de ligne cible est égal à un seuil de quantité et que la gravité de la première défaillance de ligne cible est supérieure à une deuxième gravité, ou lorsque le classement d'occurrence de la première défaillance de ligne cible est supérieur à un seuil de quantité et que la gravité de la première défaillance de ligne cible est supérieure ou égale à une deuxième gravité,
le mode de réparation de la première défaillance de ligne cible est un procédé de réparation matérielle post-emballage ;
lorsque le classement d'occurrence de la première défaillance de ligne cible est égal à un seuil de quantité et que la gravité de la première défaillance de ligne cible est égale à une deuxième gravité,
le mode de réparation de la première défaillance de ligne cible est l'un d'un procédé de réparation matérielle post-emballage ou d'un procédé de réparation logicielle post-emballage ;
autrement, le mode de réparation de la première défaillance de ligne cible est un procédé de réparation logicielle post-emballage ;
dans lequel l'appareil de détermination comprend en outre un module de traitement, dans lequel le module de traitement (703) est configuré pour entrer des informations d'adresse et des quantités de défaillances de bits et/ou de défaillances de cellules dans les défaillances de ligne qui sont comprises dans les informations concernant la pluralité de défaillances de ligne dans un modèle de notation, pour obtenir les gravités de la pluralité de défaillances de ligne, dans lequel le modèle de notation est configuré pour évaluer une gravité d'une défaillance de ligne.

6. Appareil de détermination selon la revendication 5, dans lequel
des informations concernant une défaillance de ligne comprennent spécifiquement un classement d'occurrence de la défaillance de ligne et un score de santé de la défaillance de ligne, et le score de santé est configuré pour identifier une gravité de la défaillance de ligne.

7. Appareil de détermination selon la revendication 5 ou 6, dans lequel
le module de détermination (702) est configuré pour déterminer la première défaillance de ligne cible à partir de la pluralité de défaillances de ligne sur la base de la gravité de chacune de la pluralité de défaillances de ligne, dans lequel la pluralité de défaillances de ligne sont des défaillances de ligne qui surviennent sur la mémoire dans un même intervalle de temps de redémarrage, l'intervalle de temps de redémarrage est configuré pour indiquer une période de temps allant du dernier temps de redémarrage du serveur à un temps de redémarrage actuel du serveur, et la gravité de la première défaillance de ligne cible est supérieure ou égale à une première gravité.

8. Appareil de détermination selon l'une quelconque des revendications 5 à 7, dans lequel l'appareil de détermination comprend en outre un module de réparation (704) ;
le module de détermination (702) est configuré pour : lorsqu'il y a une ligne inactive dans une zone de stockage redondante dans la mémoire, déterminer une seconde défaillance de ligne cible à partir d'au moins une défaillance de ligne non cible sur la base d'une gravité de chacune de l'au moins une défaillance de ligne non cible, dans lequel l'au moins une défaillance de ligne non cible est une défaillance de ligne non cible qui survient sur la mémoire dans un même intervalle de temps de redémarrage, une gravité de la seconde défaillance de ligne cible est supérieure ou égale à une troisième gravité et un mode de réparation de la seconde défaillance de ligne cible est un mode de réparation logicielle post-emballage ; et
le module de réparation (704) est configuré pour réparer la seconde défaillance de ligne cible selon le mode de réparation de la seconde défaillance de ligne cible.

9. Dispositif informatique, comprenant un stockage et un processeur, dans lequel le stockage est couplé au processeur, le stockage est configuré pour stocker un code de programme informatique, le code de programme informatique comprend des instructions informatiques, et lorsque les instructions informatiques sont exécutées par le processeur, le processeur est activé pour réaliser le procédé selon l'une quelconque des revendications 1 à 4.

10. Serveur, comprenant un stockage (102), un processeur (101) et un BMC, dans lequel le BMC est configuré pour réaliser le procédé selon l'une quelconque des revendications 1 à 4.

11. Serveur, comprenant un stockage (102), un processeur (101) et un BMC, dans lequel le processeur (101) est configuré pour réaliser le procédé selon l'une quelconque des revendications 1 à 4.
